(19) Europäisches Patentamt
European Patent Office
Office européen des brevets

(11) **EP 4 273 094 A1**

(12) **EUROPEAN PATENT APPLICATION**
published in accordance with Art. 153(4) EPC

(43) Date of publication:
**08.11.2023 Bulletin 2023/45**

(21) Application number: **21923022.4**

(22) Date of filing: **27.09.2021**

(51) International Patent Classification (IPC):
**C01B 21/064** (2006.01)  **C04B 35/5833** (2006.01)
**H05H 1/46** (2006.01)

(52) Cooperative Patent Classification (CPC):
**C01B 21/064; C04B 35/583; H05H 1/46**

(86) International application number:
**PCT/JP2021/035467**

(87) International publication number:
**WO 2022/163015 (04.08.2022 Gazette 2022/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.01.2021 JP 2021010533**

(71) Applicant: **JFE Steel Corporation**
**Tokyo 100-0011 (JP)**

(72) Inventors:
• **MASUOKA Hiroyuki**
**Tokyo 100-0011 (JP)**
• **TAHARA Daisuke**
**Tokyo 100-0011 (JP)**
• **MATSUZAKI Akira**
**Tokyo 100-0011 (JP)**

(74) Representative: **Haseltine Lake Kempner LLP**
**One Portwall Square**
**Portwall Lane**
**Bristol BS1 6BH (GB)**

(54) **PLASMA TREATMENT METHOD, METHOD FOR PRODUCING PLASMA-TREATED HEXAGONAL BORON NITRIDE POWDER, AND PLASMA TREATMENT DEVICE**

(57)     Provided is a hexagonal boron nitride powder that can achieve higher thermal conductivity when added as a filler to resin. A plasma treatment method of plasma-treating a hexagonal boron nitride powder under reduced pressure comprises: storing the hexagonal boron nitride powder in a treatment container; supplying a plasma generating gas into the treatment container and maintaining inside of the treatment container at a pressure lower than atmospheric pressure; applying high frequency waves to an electrode installed outside the treatment container while rotating the treatment container about a central axis of the treatment container as a rotation axis in a state in which the rotation axis of the treatment container is inclined with respect to horizontal, to plasma-treat the hexagonal boron nitride powder in the treatment container; and cooling one or both of the treatment container and the electrode during the plasma treatment.

FIG. 1

EP 4 273 094 A1

**Description**

TECHNICAL FIELD

The present disclosure relates to a plasma treatment method of plasma-treating a hexagonal boron nitride powder under reduced pressure. The present disclosure also relates to a method of producing a plasma-treated hexagonal boron nitride powder, and a plasma treatment device that plasma-treats a hexagonal boron nitride powder under reduced pressure.

BACKGROUND

With the increase of the energy density due to the miniaturization of electronics, the amount of heat generated per unit volume has increased in recent years. Insulating materials forming electronics are thus strongly required to have high heat dissipation property.

As such insulating material, resin such as epoxy resin is widely used for its high insulation withstand voltage and formability. However, the desired heat dissipation property cannot be achieved with resin alone since resin has low thermal conductivity. In view of this, an inorganic filler having high thermal conductivity and electrical insulation property is commonly added to resin in order to enhance thermal conduction.

As the inorganic filler, powders of various materials such as hexagonal boron nitride and aluminum nitride are used. In particular, hexagonal boron nitride has excellent properties such as thermal stability, chemical stability, and electrical insulation property, and therefore is widely used as a thermal conductive filler added to an insulating material.

However, since hexagonal boron nitride particles have a scaly shape derived from its crystal structure, when particles of a hexagonal boron nitride powder are added to resin, the scaly particles are oriented parallel to each other, as a result of which high thermal conductivity can be obtained in a direction parallel to the surfaces of the scaly particles but sufficient thermal conductivity cannot be obtained in a direction perpendicular to the surfaces of the scaly particles. For example, in the case of using a hexagonal boron nitride powder as a filler for a thermal conductive sheet, the surfaces of the scaly particles are oriented parallel to the surface of the sheet, so that the thermal conductivity in the thickness direction of the thermal conductive sheet is insufficient.

To reduce the anisotropy of thermal conductivity, the use of, as a filler, agglomerated particles (secondary particles) obtained by agglomerating scaly hexagonal boron nitride particles as primary particles is proposed (for example, JP 2019-116401 A (PTL 1)). Since the agglomerated particles contain primary particles of various directions, the anisotropy of thermal conductivity is low, and high thermal conductivity can be achieved regardless of the direction.

Plasma treatment of inorganic fillers is also known as a method for improving the properties of inorganic fillers. For example, JP 2015-137335 A (PTL 2) proposes a technique of plasma-treating a boron nitride powder to introduce amino groups onto the surface of the boron nitride powder.

CITATION LIST

Patent Literature

  PTL 1: JP 2019-116401 A
  PTL 2: JP 2015-137335 A

SUMMARY

(Technical Problem)

The foregoing techniques can improve the performance of a hexagonal boron nitride powder as a filler. However, given that the amount of heat generated per unit volume has further increased due to further miniaturization of electronics in recent years, insulating materials forming electronics are required to have higher heat dissipation property.

It could therefore be helpful to provide a hexagonal boron nitride powder that can achieve higher thermal conductivity when added as a filler to resin. It could also be helpful to provide a plasma treatment method, a method of producing a plasma-treated hexagonal boron nitride powder, and a plasma treatment device that can fulfill the object stated above.

(Solution to Problem)

First, our discoveries as a result of examination will be described below. In the following description, the "thermal conductivity" of a hexagonal boron nitride powder denotes the thermal conductivity of a resin material to which the hexagonal boron nitride powder has been added as a filler.

Atmospheric pressure plasma treatment is typically used as plasma treatment intended for surface modification and the like. Atmospheric pressure plasma treatment is advantageous in that, since treatment can be performed under atmospheric pressure, the object to be treated is easy to handle and there is no need for a pressure reduction device. Atmospheric pressure plasma treatment is used in the examples in PTL 2.

However, our examination revealed that, in the case where a hexagonal boron nitride powder having an agglomerated structure is subjected to atmospheric pressure plasma treatment, sufficient thermal conductivity cannot be achieved. This is considered to be because, as a result of atmospheric pressure plasma treatment, the agglomerated structure is destroyed and the anisotropy of thermal conductivity increases.

Meanwhile, we found out that reduced pressure plasma treatment can further improve the thermal conductivity of a hexagonal boron nitride powder having an agglomerated structure.

Reduced pressure plasma is a type of low-temperature plasma. In reduced pressure plasma, only electrons generated by ionization have high energy (several eV to several tens of eV), and gas atoms and molecules and ions generated by ionization have low energy (0.1 eV or less) comparable to that at room temperature. Plasma treatment can be performed at a low temperature by utilizing the high energy of the electrons.

However, common reduced pressure plasma treatment devices are mostly designed to treat substrate-like or sheet-like objects, and cannot treat powders efficiently. For example, in the case where a powder is spread on a flat stage and irradiated with plasma from above, only the surface layer of the spread powder is treated and the powder inside is not treated. There is thus a need for a method of performing reduced pressure plasma treatment on a hexagonal boron nitride powder efficiently and uniformly.

While plasma treatment intended to improve wettability and the like is usually performed for a treatment time of several tens of seconds to several minutes, we found out that long-time treatment of several tens of minutes is needed in order to improve the thermal conductivity of a hexagonal boron nitride powder by reduced pressure plasma treatment. Long-time reduced pressure plasma treatment, however, causes the temperature of the treatment container or the electrode to rise, as a result of which the plasma treatment device may be damaged. There is also a possibility that the boron nitride powder as the object to be treated deteriorates as a result of being exposed to plasma at a high temperature for a long time. Although the temperature rise can be suppressed if plasma treatment is performed intermittently, this increases the treatment time and decreases the treatment efficiency.

Upon examination, we discovered that the foregoing problems can be solved and a hexagonal boron nitride powder having excellent thermal conductivity can be obtained efficiently by performing, using a treatment container that rotates in an inclined state, reduced pressure plasma treatment while cooling one or both of the treatment container and the electrode.

The present disclosure is based on these discoveries. We provide the following.

1. A plasma treatment method of plasma-treating a hexagonal boron nitride powder under reduced pressure, the plasma treatment method comprising: storing the hexagonal boron nitride powder in a treatment container; supplying a plasma generating gas into the treatment container and maintaining inside of the treatment container at a pressure lower than atmospheric pressure; applying high frequency waves to an electrode installed outside the treatment container while rotating the treatment container about a central axis of the treatment container as a rotation axis in a state in which the rotation axis of the treatment container is inclined with respect to horizontal, to plasma-treat the hexagonal boron nitride powder in the treatment container; and cooling one or both of the treatment container and the electrode during the plasma treatment.

2. A method of producing a plasma-treated hexagonal boron nitride powder, the method comprising: storing a hexagonal boron nitride powder as a raw material in a treatment container; supplying a plasma generating gas into the treatment container and maintaining inside of the treatment container at a pressure lower than atmospheric pressure; applying high frequency waves to an electrode installed outside the treatment container while rotating the treatment container about a central axis of the treatment container as a rotation axis in a state in which the rotation axis of the treatment container is inclined with respect to horizontal, to plasma-treat the hexagonal boron nitride powder in the treatment container and obtain a plasma-treated hexagonal boron nitride powder; and cooling one or both of the treatment container and the electrode during the plasma treatment.

3. A plasma treatment device configured to plasma-treat a hexagonal boron nitride powder under reduced pressure, the plasma treatment device comprising: a treatment container configured to store the hexagonal boron nitride powder; a gas supplier configured to supply a plasma generating gas into the treatment container; a pressure reducer configured to maintain inside of the treatment container at a pressure lower than atmospheric pressure; a rotation mechanism configured to rotate the treatment container about a central axis of the treatment container as a rotation axis in a state in which the rotation axis is inclined with respect to horizontal; an electrode installed outside the treatment container; a high frequency power source configured to apply high frequency waves to the electrode; and a cooler configured to cool one or both of the treatment container and the electrode.

(Advantageous Effect)

It is thus possible to obtain a hexagonal boron nitride powder that can achieve higher thermal conductivity when added as a filler to resin. The hexagonal boron nitride powder obtained by the method according to the present disclosure can be suitably used as a thermal conductive filler added to a resin material. It is also possible to efficiently produce a hexagonal boron nitride powder having the foregoing properties. A resin material containing the hexagonal boron nitride powder obtained according to the present disclosure can be suitably used as an insulating material for electronics required to have heat dissipation property, such as a heat-dissipation insulating sheet.

BRIEF DESCRIPTION OF THE DRAWINGS

In the accompanying drawings:

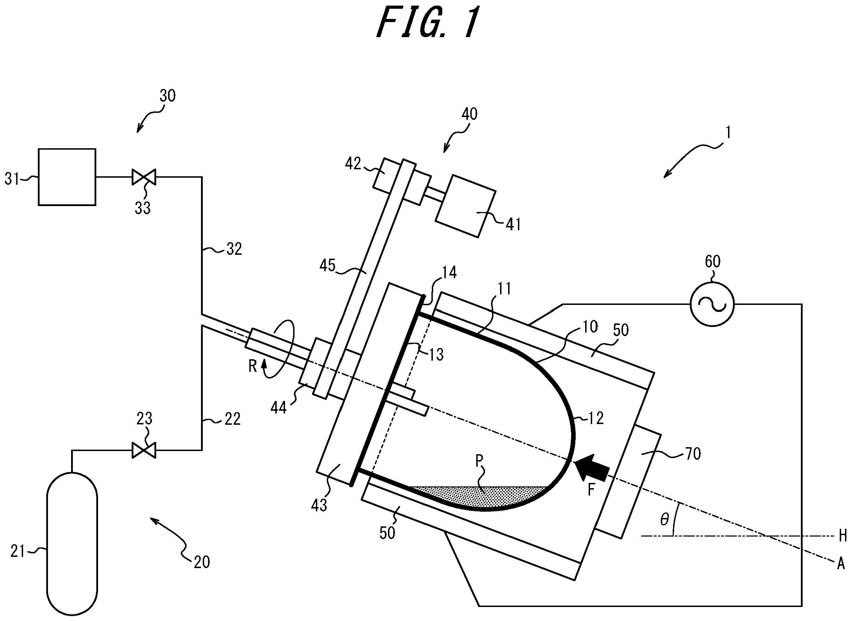

FIG. 1 is a schematic diagram illustrating the structure of a plasma treatment device according to one embodiment of the present disclosure.

DETAILED DESCRIPTION

A method for carrying out the presently disclosed techniques will be described in detail below. The following description shows preferred embodiments of the present disclosure, and the present disclosure is not limited to such.
A plasma treatment method according to one embodiment of the present disclosure includes performing plasma treatment under reduced pressure in a state in which a hexagonal boron nitride powder as an object to be treated is stored in a treatment container. A method of producing a plasma-treated hexagonal boron nitride powder according to another embodiment of the present disclosure includes performing plasma treatment under reduced pressure in a state in which a hexagonal boron nitride powder as a raw material is stored in a treatment container to obtain a plasma-treated hexagonal boron nitride powder. A plasma treatment device according to one embodiment of the present disclosure includes a treatment container configured to store a hexagonal boron nitride powder.

[Boron nitride powder]

A boron nitride powder as an object to be treated (raw material) is not limited, and any hexagonal boron nitride powder may be used. In the following description, the "hexagonal boron nitride powder" is also simply referred to as "boron nitride powder".
The shape of the boron nitride particles constituting the hexagonal boron nitride powder is not limited, but is preferably scaly.
As the hexagonal boron nitride powder, a hexagonal boron nitride powder having an agglomerated structure is preferably used. In other words, the hexagonal boron nitride powder preferably has an agglomerated structure in which hexagonal boron nitride particles as primary particles agglomerate to form secondary particles.
The hexagonal boron nitride powder having the agglomerated structure has reduced anisotropy of thermal conductivity, and therefore achieves higher thermal conductivity when added as a filler to a resin material, as mentioned above. Moreover, the boron nitride powder having the agglomerated structure has a smaller specific surface area than a boron nitride powder not having the agglomerated structure. Hence, the use of the boron nitride powder having the agglomerated structure can reduce the contact area between the boron nitride powder and the resin when the boron nitride powder is mixed with the resin, and lower the viscosity of the resin composition. Thus, in the case where the boron nitride powder has the agglomerated structure, the production of the resin material is facilitated.
Furthermore, since reduced pressure plasma treatment is employed in the present disclosure, high thermal conductivity can be achieved without destroying the agglomerated structure of the hexagonal boron nitride powder.

(Major axis length of primary particles)

The major axis length of the particles (primary particles) constituting the boron nitride powder is preferably 1 $\mu$m or more. If the major axis length is 1 $\mu$m or more, the formation of the agglomerated structure is facilitated. The major axis length of the primary particles is preferably 10 $\mu$m or less. If the major axis length is 10 $\mu$m or less, high-temperature heating for a long time is unnecessary for production, so that production can be facilitated.
The major axis length of the primary particles can be measured using a scanning electron microscope (SEM).

Specifically, a secondary electron image is taken at an accelerating voltage of 1 kV, and the size of a scaly boron nitride particle having the largest area in one agglomerate is taken to be the major axis length. Here, the major axis length is the length in the SEM image. The major axis length of the primary particles is unchanged by plasma treatment. Hence, the major axis length of the primary particles of the boron nitride powder as the object to be treated (raw material) is equal to the major axis length of the primary particles of the finally obtained plasma-treated hexagonal boron nitride powder.

(Median size of secondary particles)

In the case where the boron nitride powder has the agglomerated structure, the median size of the secondary particles is preferably 20 $\mu$m or more. If the median size of the secondary particles is 20 $\mu$m or more, the specific surface area is small and the increase in viscosity when the boron nitride powder is mixed with the resin can be suppressed, so that the resin material can be formed easily. The median size of the secondary particles is preferably 150 $\mu$m or less. If the median size of the secondary particles is 150 $\mu$m or less, high-temperature heating for a long time is unnecessary for production, so that production can be facilitated.

In the present disclosure, the median size of the secondary particles denotes median size D50 in the volume-based particle size distribution (cumulative distribution) measured using a laser diffraction particle size distribution measuring device. More specifically, the median size of the secondary particles can be determined from the volume-based particle size distribution measured at a discharge pressure of 0.01 MPa using a laser diffraction particle size distribution measuring device (MASTERSIZER 3000 produced by Malvern Panalytical). As mentioned above, since reduced pressure plasma treatment is employed in the present disclosure, the agglomerated structure of the boron nitride powder is not destroyed. Accordingly, the median size of the secondary particles is unchanged by plasma treatment. Hence, the median size of the secondary particles of the boron nitride powder as the object to be treated (raw material) is equal to the median size of the secondary particles of the finally obtained plasma-treated hexagonal boron nitride powder.

[Treatment container]

As the treatment container, any container that is capable of storing the hexagonal boron nitride powder to be treated and can be subjected to reduced pressure plasma treatment may be used. Typically, it is preferable to use a treatment container made of glass.

Although the shape of the treatment container is not limited, it is preferable to use a treatment container having a substantially cylindrical body because it is used while being rotated as described later. More preferably, the treatment container has a substantially cylindrical body, a bottom located at one end of the body, and an opening located at the other end of the body. The treatment container is preferably round-bottomed, i.e. has a curved bottom, so that the boron nitride powder in the treatment container will be smoothly stirred when the treatment container is rotated.

The treatment container preferably has one or more protrusions for promoting stirring on the inner surface. As a result of the protrusions being provided on the inner surface of the treatment container, the hexagonal boron nitride powder can be stirred more effectively when the treatment container is rotated. The protrusions are preferably provided on one or both of the side surface and the bottom surface of the treatment container. The number of protrusions is not limited, but is preferably 2 or more and more preferably 3 or more from the viewpoint of enhancing the stirring effect. If the number of protrusions is excessively large, the effect is saturated, and the structure of the treatment container is complex, making it difficult to produce the treatment container. The number of protrusions is therefore preferably 10 or less, and more preferably 5 or less. In the case where the treatment container has a plurality of protrusions, the plurality of protrusions are preferably arranged point-symmetrically about the rotation axis of the treatment container.

The shape of the protrusions is not limited, and may be any shape. For example, the protrusions may be ridged protrusions. The method of forming each protrusion is not limited, and may be any method. For example, in the case where the treatment container is made of glass, in a state in which a part of the treatment container is heated and softened, the softened part is pressed inward from the outside to form a protrusion.

[Gas supply and pressure reduction]

In the present disclosure, plasma generating gas (i.e. gas for plasma generation) is supplied into the treatment container, and the inside of the treatment container is maintained at a pressure lower than atmospheric pressure.

The plasma generating gas is not limited, and any gas may be used. For example, one or more gases selected from the group consisting of $CO_2$, $CO$, $O_2$, $N_2$, $H_2O$, $Ar$, $He$, and $Ne$ may be used. Moreover, plasma treatment may be performed in multiple stages under different atmospheres by changing the gas used during the plasma treatment.

The plasma treatment device according to one embodiment of the present disclosure includes a gas supplier that supplies the plasma generating gas into the treatment container. As the gas supplier, any device capable of supplying the required gas may be used. For example, the gas supplier may include one or more gas cylinders. Moreover, the gas supplier preferably includes a flow adjuster such as a mass flow controller.

The pressure in the treatment container is not limited, and may be any pressure at which reduced pressure plasma treatment is possible. Typically, the pressure is preferably 1 Pa to 100 Pa. If the pressure in the atmosphere when performing plasma treatment is 1 Pa or more and 100 Pa or less, the effect of plasma treatment can be further enhanced.

The plasma treatment device according to one embodiment of the present disclosure includes a pressure reducer that maintains the inside of the treatment container at a pressure lower than atmospheric pressure. As the pressure reducer, any device capable of maintaining the required pressure may be used. For example, a vacuum pump may be used as the pressure reducer. The plasma treatment device according to the present disclosure preferably includes a pressure gauge that measures the pressure in the treatment container or in a space communicating with the treatment container.

[Rotation]

In the present disclosure, plasma treatment is performed while rotating the treatment container about the central axis of the treatment container as the rotation axis. During this, the rotation axis of the treatment container is inclined with respect to the horizontal. The plasma treatment device according to one embodiment of the present disclosure includes a rotation mechanism that rotates the treatment container about the central axis of the treatment container as the rotation axis in a state in which the rotation axis is inclined with respect to the horizontal.

By rotating the treatment container in an inclined state in this way, it is possible to effectively stir the boron nitride powder in the treatment container and, even in the case where the amount of the boron nitride powder is large, uniformly plasma-treat the boron nitride powder in a short time. The "state in which the rotation axis is inclined with respect to the horizontal" is defined as a state in which the smaller one of the angles formed between the rotation axis and the horizontal plane is more than 0° and less than 90°. The smaller one of the angles formed between the rotation axis and the horizontal plane is hereafter also referred to as the "inclination angle of the rotation axis" or simply the "inclination angle".

From the viewpoint of enhancing the efficiency of stirring the hexagonal boron nitride powder in the treatment container, the inclination angle of the rotation axis is preferably 5° or more, and more preferably 20° or more. The inclination angle is preferably 85° or less, and more preferably 75° or less.

The rotation speed of the treatment container is not limited, and may be any speed. Typically, the rotation speed is adjusted to appropriately stir the hexagonal boron nitride powder. For example, the rotation speed is preferably 1 rpm to 50 rpm, and more preferably 5 rpm to 30 rpm.

[Application of high frequency waves]

In the present disclosure, in a state in which the treatment container is rotated, high frequency waves are applied to an electrode installed outside the treatment container to plasma-treat the hexagonal boron nitride powder in the treatment container. The plasma-treated hexagonal boron nitride powder can thus be obtained. The plasma treatment device according to one embodiment of the present disclosure includes the electrode installed outside the treatment container, and a high frequency power source that applies high frequency waves to the electrode.

The conditions when applying high frequency waves are not limited, and are adjusted depending on the type and pressure of the gas used, the dimensions of the treatment container, etc. For example, the voltage is preferably 1.0 kV to 5.0 kV, and the RF power is preferably 50 W to 10,000 W.

The time required for plasma treatment is not limited because it depends on the amount of hexagonal boron nitride powder to be treated and the stirring conditions, and is adjusted to obtain the desired properties. A relatively long time is required in order to improve the thermal conductivity of the hexagonal boron nitride powder, as mentioned above. Hence, typically, the plasma treatment time is preferably 10 minutes or more, and more preferably 20 minutes or more. If the treatment time is excessively long, the effect is saturated, and the productivity decreases. The plasma treatment time is therefore preferably 100 minutes or less, and more preferably 60 minutes or less.

[Cooling]

In the present disclosure, it is important to cool one or both of the treatment container and the electrode during the plasma treatment. The plasma treatment device according to one embodiment of the present disclosure includes a cooler that cools one or both of the treatment container and the electrode. By cooling at least one of the treatment container and the electrode, it is possible to prevent the temperature rise of the device and perform the plasma treatment continuously even for a long time. Efficient plasma treatment can thus be achieved.

6

The cooling may be performed using any device without limitation. For example, the cooling may be performed by one or both of air cooling and heat exchange with a refrigerant. In the case of air cooling, for example, a blower may be used as the cooler. In the case of cooling by heat exchange, for example, a heat exchanger located so as to be in contact with one or both of the treatment container and the electrode and a coolant circulation device that circulates a coolant through the heat exchanger may be used as the cooler. As the heat exchanger, for example, a tube that is located so as to be in contact with one or both of the treatment container and the electrode and through which the coolant flows may be used.

The electrode preferably includes heat dissipation fins to promote heat dissipation.

An example of the structure of the plasma treatment device according to one embodiment of the present disclosure will be described in more detail below, with reference to the drawing.

FIG. 1 is a schematic diagram illustrating the structure of a plasma treatment device 1 according to one embodiment of the present disclosure. The plasma treatment device 1 includes a treatment container 10 that stores a hexagonal boron nitride powder P. The treatment container 10 is a round-bottomed glass container, and includes a substantially cylindrical body 11, a bottom 12 connected to one end of the body 11 and formed with a curved surface that is convex outward, and an opening 13 located at the other end of the body 11. The opening 13 is provided with a flange 14 projecting to the outside the treatment container 10. The flange 14 is fixed to the below-described support member 43 by a clamp (not illustrated).

The plasma treatment device 1 includes a gas supplier 20 that supplies plasma generating gas into the treatment container 10. The gas supplier 20 includes a gas cylinder 21, a pipe 22, and a flow adjusting valve 23 located on the pipe 22. Although only one gas cylinder 21 is illustrated in FIG. 1, in the case of using an atmosphere gas composed of a plurality of gases, a plurality of gas cylinders and corresponding pipes and flow adjusting valves can be used.

The plasma treatment device 1 also includes a pressure reducer 30 that maintains the inside of the treatment container 10 at a pressure lower than atmospheric pressure. The pressure reducer 30 includes a vacuum pump 31, a pipe 32, and a valve 33 located on the pipe 32.

The plasma treatment device 1 includes a rotation mechanism 40 that rotates the treatment container 10. The rotation mechanism 40 includes a drive motor 41, a first pulley 42 connected to the rotation shaft of the motor 41, the support member 43 supporting the treatment container 10, a second pulley 44 connected to the support member 43, and a belt 45 stretched between the first pulley 42 and the second pulley 44. The rotation of the motor 41 is transmitted to the support member 43 by the belt 45, and the treatment container 10 fixed to the support member 43 rotates about the central axis of the treatment container 10 as the rotation axis as indicated by arrow R. The rotation axis is indicated by line A in FIG. 1. The rotation axis of the treatment container 10 is inclined at inclination angle θ with respect to the horizontal indicated by line H, as illustrated in FIG. 1.

Although an embodiment in which the rotation of the motor is transmitted by the pulleys and the belt is illustrated in FIG. 1, the rotation transmission method is not limited to such. For example, the rotation may be transmitted using a chain and sprockets, or using a plurality of gears. Alternatively, a direct drive system that rotates the treatment container directly by the rotation of the motor may be used.

An electrode 50 is installed outside the treatment container 10, and is electrically connected to a high frequency power source 60 for applying high frequency waves to the electrode 50. The electrode 50 preferably has a substantially cylindrical shape so as to surround the periphery of the treatment container 10 as illustrated in FIG. 1.

The plasma treatment device 1 further includes a cooler 70. In this embodiment, the cooler 70 is a cooling fan, and has a function of cooling the treatment container 10 and the electrode 50 by blowing air in the direction indicated by arrow F. Although air cooling by a cooling fan is used in this embodiment, other cooling methods such as water cooling may also be used as mentioned above. It is also preferable to use both air cooling and water cooling.

EXAMPLES

A hexagonal boron nitride powder as a raw material (hereafter referred to as "raw material boron nitride powder") was subjected to plasma treatment under the following conditions to obtain a plasma-treated hexagonal boron nitride powder.

(Raw material boron nitride powder)

HP40MF100 (Mizushima Ferroalloy Co., Ltd.) was used as the raw material boron nitride powder. HP40MF100 is a boron nitride powder having an agglomerated structure in which scaly primary particles made of hexagonal boron nitride agglomerate to form secondary particles. The major axis length of the primary particles is 10 μm, and the median size of the secondary particles is 40 μm.

(Plasma treatment conditions)

The raw material boron nitride powder was subjected to reduced pressure plasma treatment using a plasma treatment device having the structure illustrated in FIG. 1, under the conditions shown in Table 1. Specifically, 20 g of the raw material boron nitride powder was placed in a treatment container made of glass, the treatment container was sealed, and the pressure inside the treatment container was reduced to 1 Pa or less. Following this, a gas having the composition shown in Table 1 was introduced into the treatment container at a flow rate of 10 mL/min, and the pressure inside the treatment container was adjusted to the value shown in Table 1. After this, in a state in which air was blown toward the treatment container and the electrode using a blower fan as a cooler, high frequency waves were applied under the conditions shown in Table 1 to perform reduced pressure plasma treatment. The rotation speed and inclination angle of the treatment container are shown in Table 1.

For comparison, no plasma treatment was performed in Comparative Example No. 16. In Comparative Example No. 17, plasma treatment was performed for only 1 minute without cooling.

(Thermal conductivity)

The thermal conductivity of each obtained plasma-treated hexagonal boron nitride powder was evaluated by the following procedure.

Bisphenol F type epoxy resin (jER 807 produced by Mitsubishi Chemical Corporation), the foregoing boron nitride powder, methyl cellosolve as a solvent, and a modified alicyclic amine-based curing agent (jER CURE 113 produced by Mitsubishi Chemical Corporation) were mixed at the ratio shown in Table 1. The filling rate of the boron nitride powder in the resin material of each example was 70 vol%. Herein, the filling rate of boron nitride is the ratio of the boron nitride powder to the total solid content of the resin material. The volumes were calculated from the masses of the mixed epoxy resin, curing agent, and boron nitride, and the filling rate was calculated as the ratio of boron nitride in the total volume by the following formula:

$$\text{Filling rate (vol\%)} = (\text{volume of BN})/(\text{volume of BN} + \text{volume of epoxy resin} + \text{volume of curing agent}).$$

The following density values were used in the calculation:

Boron nitride powder: 2.26 g/cm$^3$
Epoxy resin: 1.20 g/cm$^3$
Curing agent: 0.945 g/cm$^3$.

Next, the mixture was kneaded for 2 minutes at room temperature using a rotation/revolution mixer (ARV-310 produced by THINKY Corporation), and then applied onto a polyimide film using a hand coater that gave a film thickness of 200 μm after forming. After drying, hot press forming (170 °C, 80 kgf·cm$^2$) was performed to obtain a resin material.

The thermal diffusivity, density, and specific heat of each obtained resin material were measured, and the measured thermal diffusivity, density, and specific heat were multiplied to yield the thermal conductivity of the resin material in the thickness direction. The obtained thermal conductivity is shown in Table 1. The thermal diffusivity, the density, and the specific heat were measured by the following methods:

- Thermal diffusivity: laser flash thermal constant measuring device (TC-3000 produced by SHINKU-RIKO Inc.).
- Density: Archimedes method.
- Specific heat: differential scanning calorimetry (DSC) method.

[Table 1]

Table 1

| No. | Plasma treatment conditions | | | | | | Evaluation result | Remarks |
|---|---|---|---|---|---|---|---|---|
| | Gas composition (vol%) | Pressure (Pa) | Voltage (kV) | Rotation speed (rpm) | Inclination angle (degrees) | Treatment time (min) | Thermal conductivity (W/m.K) | |
| 1 | 100%CO$_2$ | 20 | 2.5 | 20 | 60 | 30 | 13.2 | Example |
| 2 | 100%CO$_2$ | 50 | 2.5 | 20 | 60 | 30 | 12.8 | Example |
| 3 | 100%CO$_2$ | 100 | 2.5 | 20 | 60 | 30 | 12.5 | Example |
| 4 | 100%CO$_2$ | 20 | 1 | 20 | 60 | 30 | 11.6 | Example |
| 5 | 100%CO$_2$ | 20 | 3 | 20 | 60 | 30 | 13.7 | Example |
| 6 | 100%CO$_2$ | 20 | 5 | 20 | 60 | 30 | 13.8 | Example |
| 7 | 100%CO$_2$ | 20 | 3 | 1 | 60 | 30 | 13.5 | Example |
| 8 | 100%CO$_2$ | 20 | 3 | 50 | 60 | 30 | 13.9 | Example |
| 9 | 100%CO$_2$ | 20 | 3 | 20 | 5 | 30 | 14.0 | Example |
| 10 | 100%CO$_2$ | 20 | 3 | 20 | 20 | 30 | 13.8 | Example |
| 11 | 100%CO$_2$ | 20 | 3 | 20 | 75 | 30 | 12.5 | Example |
| 12 | 100%CO$_2$ | 20 | 3 | 20 | 85 | 30 | 12.0 | Example |
| 13 | 100%CO$_2$ | 20 | 3 | 20 | 60 | 10 | 12.0 | Example |
| 14 | 100%CO$_2$ | 20 | 3 | 20 | 60 | 20 | 12.8 | Example |
| 15 | 100%CO$_2$ | 20 | 3 | 20 | 60 | 60 | 14.4 | Example |
| 16 | - | - | - | - | - | - | 10.5 | Comparative Example |
| 17 | 100%CO$_2$ | 20 | 3 | 50 | 60 | 1 | 10.8 | Comparative Example |
| 18 | 100%O$_2$ | 20 | 1 | 20 | 60 | 30 | 11.2 | Example |
| 19 | 100%O$_2$ | 20 | 3 | 20 | 60 | 30 | 11.9 | Example |
| 20 | 100%O$_2$ | 20 | 5 | 20 | 60 | 30 | 12.5 | Example |
| 21 | 100%N$_2$ | 20 | 1 | 20 | 60 | 30 | 11.4 | Example |

| No. | Plasma treatment conditions | | | | | | Evaluation result | Remarks |
|---|---|---|---|---|---|---|---|---|
| | Gas composition (vol%) | Pressure (Pa) | Voltage (kV) | Rotation speed (rpm) | Inclination angle (degrees) | Treatment time (min) | Thermal conductivity (W/m.K) | |
| 22 | 100%$N_2$ | 20 | 3 | 20 | 60 | 30 | 12.1 | Example |
| 23 | 100%$N_2$ | 20 | 5 | 20 | 60 | 30 | 12.5 | Example |
| 24 | 90%$CO_2$, 10%$N_2$ | 20 | 5 | 20 | 60 | 30 | 13.2 | Example |

EP 4 273 094 A1

As can be seen from the results shown in Table 1, in each Example satisfying the conditions according to the present disclosure, a hexagonal boron nitride powder having excellent thermal conductivity was obtained efficiently. In addition, since cooling was performed in each Example, it was possible to stably perform plasma treatment for a long time while suppressing temperature rise. In each Comparative Example not satisfying the conditions according to the present disclosure, the obtained hexagonal boron nitride powder was inferior in thermal conductivity. In Comparative Example No. 17, plasma treatment was possible without cooling for a short time of about 1 minute, but a hexagonal boron nitride powder having excellent thermal conductivity could not be obtained.

REFERENCE SIGNS LIST

| | |
|---|---|
| 1 | plasma treatment device |
| 10 | treatment container |
| 11 | body |
| 12 | bottom |
| 13 | opening |
| 14 | flange |
| 20 | gas supplier |
| 21 | gas cylinder |
| 22 | pipe |
| 23 | flow adjusting valve |
| 30 | pressure reducer |
| 31 | vacuum pump |
| 32 | pipe |
| 33 | valve |
| 40 | rotation mechanism |
| 41 | motor |
| 42 | first pulley |
| 43 | support member |
| 44 | second pulley |
| 50 | electrode |
| 60 | high frequency power source |
| 70 | cooler |
| A | rotation axis |
| H | horizontal |
| P | hexagonal boron nitride powder |
| R | rotation direction |
| θ | inclination angle |

**Claims**

1. A plasma treatment method of plasma-treating a hexagonal boron nitride powder under reduced pressure, the plasma treatment method comprising:

    storing the hexagonal boron nitride powder in a treatment container;
    supplying a plasma generating gas into the treatment container and maintaining inside of the treatment container at a pressure lower than atmospheric pressure;
    applying high frequency waves to an electrode installed outside the treatment container while rotating the treatment container about a central axis of the treatment container as a rotation axis in a state in which the rotation axis of the treatment container is inclined with respect to horizontal, to plasma-treat the hexagonal boron nitride powder in the treatment container; and
    cooling one or both of the treatment container and the electrode during the plasma treatment.

2. A method of producing a plasma-treated hexagonal boron nitride powder, the method comprising:

    storing a hexagonal boron nitride powder as a raw material in a treatment container;

supplying a plasma generating gas into the treatment container and maintaining inside of the treatment container at a pressure lower than atmospheric pressure;

applying high frequency waves to an electrode installed outside the treatment container while rotating the treatment container about a central axis of the treatment container as a rotation axis in a state in which the rotation axis of the treatment container is inclined with respect to horizontal, to plasma-treat the hexagonal boron nitride powder in the treatment container and obtain a plasma-treated hexagonal boron nitride powder; and cooling one or both of the treatment container and the electrode during the plasma treatment.

3. A plasma treatment device configured to plasma-treat a hexagonal boron nitride powder under reduced pressure, the plasma treatment device comprising:

a treatment container configured to store the hexagonal boron nitride powder;

a gas supplier configured to supply a plasma generating gas into the treatment container;

a pressure reducer configured to maintain inside of the treatment container at a pressure lower than atmospheric pressure;

a rotation mechanism configured to rotate the treatment container about a central axis of the treatment container as a rotation axis in a state in which the rotation axis is inclined with respect to horizontal;

an electrode installed outside the treatment container;

a high frequency power source configured to apply high frequency waves to the electrode; and

a cooler configured to cool one or both of the treatment container and the electrode.

# FIG. 1

# EP 4 273 094 A1

<table>
<tr><td colspan="2" align="center">INTERNATIONAL SEARCH REPORT</td><td>International application No.<br><br>**PCT/JP2021/035467**</td></tr>
</table>

**A. CLASSIFICATION OF SUBJECT MATTER**

*C01B 21/064*(2006.01)i; *C04B 35/5833*(2006.01)i; *H05H 1/46*(2006.01)i
FI: C01B21/064 M; C04B35/5833; H05H1/46 A

According to International Patent Classification (IPC) or to both national classification and IPC

**B. FIELDS SEARCHED**

Minimum documentation searched (classification system followed by classification symbols)

C01B21/064; C04B35/5833; H05H1/46

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2010-510168 A (THE REG. OF THE UNIVERSITY OF CALIFORNIA) 02 April 2010 (2010-04-02)<br>    paragraphs [0009], [0022]-[0027], fig. 3, 6 | 1-3 |
| Y | JP 2017-012970 A (DENSHI GIKEN CO., LTD.) 19 January 2017 (2017-01-19)<br>    paragraphs [0083], [0093]-[0102], fig. 10 | 1-3 |
| Y | JP 2014-157760 A (SAKIGAKE HANDOTAI KK) 28 August 2014 (2014-08-28)<br>    paragraphs [0020]-[0025], fig. 1, 2 | 1-3 |
| Y | WO 2019/210891 A1 (FYZIKALNI USTAV AV CR, V.V.I.) 07 November 2019 (2019-11-07)<br>    paragraph [0045], fig. 2 | 1-3 |
| A | KR 10-2019-0023273 A (KOREA INSTITUTE OF SCIENCE AND TECHNOLOGY) 08 March 2019 (2019-03-08)<br>    entire text | 1-3 |
| P, A | WO 2021/131669 A1 (FUJIFILM CORP.) 01 July 2021 (2021-07-01)<br>    entire text | 1-3 |

☑ Further documents are listed in the continuation of Box C.      ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br><br>**11 November 2021** | Date of mailing of the international search report<br><br>**22 November 2021** |
|---|---|
| Name and mailing address of the ISA/JP<br><br>**Japan Patent Office (ISA/JP)**<br>**3-4-3 Kasumigaseki, Chiyoda-ku, Tokyo 100-8915**<br>**Japan** | Authorized officer<br><br><br><br>Telephone No. |

Form PCT/ISA/210 (second sheet) (January 2015)

## INTERNATIONAL SEARCH REPORT

| | International application No. |
|---|---|
| | **PCT/JP2021/035467** |

### C.    DOCUMENTS CONSIDERED TO BE RELEVANT

| Category* | Citation of document, with indication, where appropriate, of the relevant passages | Relevant to claim No. |
|---|---|---|
| P, A | WO 2021/070690 A1 (JFE STEEL CORP.) 15 April 2021 (2021-04-15)<br>entire text | 1-3 |

Form PCT/ISA/210 (second sheet) (January 2015)

**INTERNATIONAL SEARCH REPORT**
Information on patent family members

International application No.

**PCT/JP2021/035467**

| Patent document cited in search report | | | Publication date (day/month/year) | Patent family member(s) | | | Publication date (day/month/year) |
|---|---|---|---|---|---|---|---|
| JP | 2010-510168 | A | 02 April 2010 | US 2012/0273733 A1 paragraphs [0027]-[0000], fig. 3, 6 WO 2008/140583 A2 | | | |
| JP | 2017-012970 | A | 19 January 2017 | (Family: none) | | | |
| JP | 2014-157760 | A | 28 August 2014 | (Family: none) | | | |
| WO | 2019/210891 | A1 | 07 November 2019 | EP 3788181 A1 | | | |
| KR | 10-2019-0023273 | A | 08 March 2019 | (Family: none) | | | |
| WO | 2021/131669 | A1 | 01 July 2021 | (Family: none) | | | |
| WO | 2021/070690 | A1 | 15 April 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019116401 A

- JP 2015137335 A